# EUROPEAN PATENT APPLICATION

(11) **EP 4 845 369 A1**
(43) Date of publication of application: **25.11.2026**
(21) Application number: 25840023.3
(22) Date of filing: 09.06.2025
(51) Int. Cl.: H10K 59/38, H10K 59/126, H10K 59/35

(54) **DISPLAY SUBSTRATE AND DISPLAY DEVICE**

(30) Priority: 15.07.2024 CN 202410947472
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: HU, Ming, Beijing 100176 (CN); SHI, Bo, Beijing 100176 (CN); CHEN, Youchun, Beijing 100176 (CN); SHANG, Yanyang, Beijing 100176 (CN); ZUO, Kailong, Beijing 100176 (CN); ZHANG, Shitao, Beijing 100176 (CN); HE, Ying, Beijing 100176 (CN); XIANG, Yang, Beijing 100176 (CN); QI, Puyu, Beijing 100176 (CN); NI, Zibo, Beijing 100176 (CN); SONG, Gukhwan, Beijing 100176 (CN); SHI, Ling, Beijing 100176 (CN); QIU, Yuheng, Beijing 100176 (CN); CHU, Xiaodong, Beijing 100176 (CN); FU, Jianji, Beijing 100176 (CN)
(74) Representative: AWA Sweden AB
(86) International application number: PCT/CN2025/099842
(87) International publication number: WO 2026/016672

(57) **Abstract**

The present disclosure provides a display substrate and a display apparatus. The display substrate includes a substrate, and a light-emitting layer, a color filter layer and a light-shielding layer that are located on the substrate. The light-emitting layer includes a plurality of sub-pixels arranged at intervals. The color filter layer is on a side of the light-emitting layer away from the substrate, and the color filter layer includes a plurality of color filter portions; each color filter portion includes a main body portion, at least one color filter portion includes a protruding portion connected to the main body portion, and each protruding portion is between two adjacent main body portions. The light-shielding layer is at least partially located on a side of the color filter layer away from the substrate; the light-shielding layer is provided with a plurality of openings, and an orthographic projection of each opening on the substrate falls within an orthographic projection of a respective color filter portion on the substrate. The display apparatus includes the display substrate.

## Description

### TECHNICAL FIELD

The present disclosure relates to a field of a display technology, and in particular to a display substrate and a display apparatus.

### BACKGROUND

An OLED (Organic Light-Emitting Diode) has advantages of self-luminescence, high efficiency, bright color, light weight, low power consumption and a wide operating temperature range, and has been gradually applied in fields such as large-area display, lighting and vehicle-mounted display.

### SUMMARY

The present disclosure provides a display substrate and a display apparatus.

According to a first aspect of embodiments of the present disclosure, a display substrate is provided, including:
a substrate;
a light-emitting layer located on the substrate, where the light-emitting layer includes a plurality of sub-pixels arranged at intervals;
a color filter layer located on a side of the light-emitting layer away from the substrate, where the color filter layer includes a plurality of color filter portions, each color filter portion includes a main body portion, at least one color filter portion includes a protruding portion connected to the main body portion, and each protruding portion is located between two adjacent main body portions; and
a light-shielding layer at least partially located on a side of the color filter layer away from the substrate, where the light-shielding layer is provided with a plurality of openings, and an orthographic projection of each opening on the substrate falls within an orthographic projection of a respective color filter portion on the substrate.

In an embodiment of the present disclosure, opposing portions of outlines of at least two adjacent color filter portions have a same shape.

In an embodiment of the present disclosure, each of the opposing portions of the outlines of the at least two adjacent color filter portions is linear, and the opposing linear portions of the outlines of the two adjacent color filter portions are parallel to each other.

In an embodiment of the present disclosure, the opposing portions of the outlines of the at least two adjacent color filter portions are curved.

In an embodiment of the present disclosure, at least one color filter portion is surrounded by a plurality of color filter portions, an outline of the surrounded color filter portion is a smooth closed curve, and portions of outlines of the plurality of surrounding color filter portions that oppose the surrounded color filter portion are located on a same smooth closed curve.

In an embodiment of the present disclosure, a geometric center of the smooth closed curve where the portions of the outlines of the plurality of surrounding color filter portions that oppose the surrounded color filter portion are located is a first center, a geometric center of the outline of the surrounded color filter portion is a second center, and the first center coincides with the second center.

In an embodiment of the present disclosure, partial outlines of at least two adjacent color filter portions conform to each other.

In an embodiment of the present disclosure, a maximum width of a gap between any two adjacent color filter portions is less than or equal to 3 µm.

In an embodiment of the present disclosure, the plurality of color filter portions are arranged into a plurality of first filter portion groups and a plurality of second filter portion groups, the plurality of first filter portion groups are arranged in a first direction, the plurality of second filter portion groups are arranged in a second direction, each first filter portion group includes a plurality of color filter portions arranged in the second direction, each second filter portion group includes a plurality of color filter portions arranged in the first direction, and the first direction intersects the second direction; each of the plurality of color filter portions in the color filter layer includes the main body portion and at least one protruding portion connected to the main body portion; and
a region between main body portions of two adjacent color filter portions in a same first filter portion group is filled with the protruding portion; and a region between main body portions of two adjacent color filter portions in a same second filter portion group is filled with the protruding portion.

In an embodiment of the present disclosure, the color filter layer includes color filter portions of at least three different colors; and in the color filter layer, the protruding portion filled between any two adjacent main body portions in the same first filter portion group and the protruding portion filled between any two adjacent main body portions in the same second filter portion group are both protruding portions of a same color.

In an embodiment of the present disclosure, the color filter portions of the color filter layer include a first color filter portion, a second color filter portion and a third color filter portion; for two adjacent first filter portion groups, a first color filter portion and a second color filter portion in one first filter portion group are arranged alternately, and each color filter portion in the other first filter portion group is a third color filter portion; and for two adjacent second filter portion groups, a first color filter portion and a second color filter portion in one second filter portion group are arranged alternately, and each color filter portion in the other second filter portion group is a third color filter portion; and
each first color filter portion has protruding portions on opposite sides in both the second direction and the first direction, and each of protruding portions filled between any two adjacent main body portions is a protruding portion of a first color filter portion; or each second color filter portion has protruding portions on opposite sides in both the second direction and the first direction, and each of protruding portions filled between any two adjacent main body portions is a protruding portion of a second color filter portion; or each third color filter portion has protruding portions on opposite sides in both the second direction and the first direction, each of protruding portions filled between any two adjacent main body portions is a protruding portion of a third color filter portion, and third color filter portions are formed as a continuous structure.

In an embodiment of the present disclosure, the first color is red, the second color is blue, and the third color is green.

In an embodiment of the present disclosure, the color filter layer includes color filter portions of at least three different colors; and protruding portions of two colors are filled between at least two adjacent main body portions.

In an embodiment of the present disclosure, the color filter portions of the color filter layer include a first color filter portion, a second color filter portion and a third color filter portion; for two adjacent first filter portion groups, a first color filter portion and a second color filter portion in one first filter portion group are arranged alternately, and each color filter portion in the other first filter portion group is a third color filter portion; for two adjacent second filter portion groups, a first color filter portion and a second color filter portion in one second filter portion group are arranged alternately, and each color filter portion in the other second filter portion group is a third color filter portion; each of the first color filter portion and the second color filter portion has protruding portions on opposite sides in both the first direction and the second direction; and a protruding portion of a first color filter portion and a protruding portion of a second color filter portion are filled between two adjacent main body portions in a same first filter portion group, and a protruding portion of a first color filter portion and a protruding portion of a second color filter portion are filled between two adjacent main body portions in the same second filter portion group.

In an embodiment of the present disclosure, the first color is red, the second color is blue, an area of a main body portion of the first color filter portion is equal to an area of a main body portion of the second color filter portion, and an area of a protruding portion of the first color filter portion is equal to an area of a protruding portion of the second color filter portion.

In an embodiment of the present disclosure, the color filter portions of the color filter layer include a first color filter portion, a second color filter portion and a third color filter portion; for two adjacent first filter portion groups, a first color filter portion and a second color filter portion in one first filter portion group are arranged alternately, and each color filter portion in the other first filter portion group is a third color filter portion; for two adjacent second filter portion groups, a first color filter portion and a second color filter portion in one second filter portion group are arranged alternately, and each color filter portion in the other second filter portion group is a third color filter portion; the second color filter portion or the third color filter portion has protruding portions on opposite sides in a third direction, and the third direction intersects both the first direction and the second direction; and
the second color filter portion or the third color filter portion has protruding portions on opposite sides in a fourth direction, and the fourth direction intersects both the first direction and the second direction and is perpendicular to the third direction.

In an embodiment of the present disclosure, the first color is red, the second color is blue, and the third color is green.

In an embodiment of the present disclosure, distances between a surface of each color filter portion in the color filter layer away from the substrate and the substrate are the same.

In an embodiment of the present disclosure, the display substrate further includes an insulating layer located on a side of the light-emitting layer away from the substrate, where the insulating layer is provided with a plurality of through holes, and a main body portion of each color filter portion is partially located in a respective through hole; and an edge of an orthographic projection of a bottom surface of each through hole facing the substrate on the substrate is a first edge, an edge of an orthographic projection of each color filter portion on the substrate is a second edge, and the first edge is located inside a corresponding second edge.

In an embodiment of the present disclosure, the display substrate further includes a pixel defining layer located between the substrate and the insulating layer, where the pixel defining layer is provided with a plurality of pixel openings, and at least a portion of each sub-pixel is located in a respective pixel opening; an edge of an orthographic projection of a bottom surface of each pixel opening facing the substrate on the substrate is a third edge, and the third edge is located inside a corresponding first edge.

In an embodiment of the present disclosure, a refractive index of the insulating layer is less than a refractive index of the color filter portion.

In an embodiment of the present disclosure, an edge of an orthographic projection of each opening on the substrate is a fourth edge, and the fourth edge is located outside a corresponding first edge.

In an embodiment of the present disclosure, the display substrate further includes a touch structure layer located between the light-emitting layer and the color filter layer, where the touch structure layer includes a first touch electrode layer, a second touch electrode layer located on a side of the first touch electrode layer away from the substrate, an insulating material layer located between the first touch electrode layer and the second touch electrode layer, and an insulating protective layer located on a side of the second touch electrode layer away from the substrate.

In an embodiment of the present disclosure, the insulating layer further serves as the insulating protective layer and covers the second touch electrode layer.

In an embodiment of the present disclosure, a side surface of at least one through hole of the insulating layer is provided with at least one protrusion, and the protrusion extends toward a center of the through hole where the protrusion is located.

In an embodiment of the present disclosure, a side surface of the protrusion is conical or cylindrical, or a cross section of the protrusion parallel to the substrate is semi-elliptical.

In an embodiment of the present disclosure, the side surface of the at least one through hole of the insulating layer is provided with a plurality of protrusions arranged at intervals, an axis of the protruding portion passing through a center of the color filter portion where the protruding portion is located is a first axis, an axis of the protrusion passing through the center of the through hole where the protrusion is located is a second axis, and an included angle between the first axis of the protruding portion and one of second axes of two protrusions adjacent to the protruding portion in a corresponding through hole is equal to an included angle between the first axis of the protruding portion and the other of the second axes of the two protrusions adjacent to the protruding portion in the corresponding through hole.

In an embodiment of the present disclosure, the display substrate further includes an encapsulation layer located between the light-emitting layer and the color filter layer.

In an embodiment of the present disclosure, the display substrate further includes a protective layer located on a side of the light-shielding layer away from the substrate.

According to a second aspect of embodiments of the present disclosure, a display apparatus is provided, including the display substrate described above.

In the display substrate and the display apparatus provided in embodiments of the present disclosure, by configuring that the at least one color filter portion in the color filter layer to include a protruding portion connected to a main body portion, and a protruding portion to be arranged between the main body portions of the two adjacent color filter portions, the protruding portion may reduce a gap between adjacent color filter portions, which may mitigate breakage of the light-shielding layer formed on the color filter portion caused by an excessively large distance between the adjacent color filter portions. In addition, it is also possible to mitigate color separation resulting from diffraction of light emitted by the sub-pixels when passing through the broken part of the light-shielding layer, and the problem of a display defect of black spots appearing during the display of the display substrate caused by particles, generated during the breakage of the light-shielding layer, falling at a position where the color filter portion opposes the opening of the light-shielding layer.

### BRIEF DESCRIPTION OF THE DRAWINGS

FIG. 1 is a partial schematic view of a display substrate provided in an exemplary embodiment of the present disclosure, taken along a direction perpendicular to a stacking direction of layers;
FIG. 2 is a top view of a layout of a color filter layer in a display substrate provided in an exemplary embodiment of the present disclosure;
FIG. 3 is a top view of a layout of a color filter layer in a display substrate provided in another exemplary embodiment of the present disclosure;
FIG. 4 is a top view of a layout of a color filter layer in a display substrate provided in yet another exemplary embodiment of the present disclosure;
FIG. 5 is a top view of a layout of a color filter layer in a display substrate provided in yet another exemplary embodiment of the present disclosure;
FIG. 6 is a top view of a layout of a color filter layer in a display substrate provided in yet another exemplary embodiment of the present disclosure;
FIG. 7 is a top view of a layout of a color filter layer in a display substrate provided in yet another exemplary embodiment of the present disclosure;
FIG. 8 is a top view of a layout of a color filter layer in a display substrate provided in yet another exemplary embodiment of the present disclosure;
FIG. 9 is a schematic diagram showing a positional relationship of partial structures in a display substrate provided in an exemplary embodiment of the present disclosure;
FIG. 10 is a schematic diagram showing a positional relationship of partial structures in a display substrate provided in another exemplary embodiment of the present disclosure;
FIG. 11 is a schematic diagram showing a positional relationship between a color filter layer and an insulating layer in the display substrate shown in FIG. 9;
FIG. 12 is a schematic diagram showing a positional relationship between a color filter layer and an insulating layer in the display substrate shown in FIG. 10;
FIG. 13 is a partial enlarged view of the color filter layer shown in FIG. 2; and
FIG. 14 is a partial enlarged view of the color filter layer shown in FIG. 6.

### DETAILED DESCRIPTION OF EMBODIMENTS

The technical solution in embodiments of the present disclosure will be described clearly and completely below in combination with the accompanying drawings. In a case of no conflicts, the following embodiments and features in the embodiments may be combined with each other. When the following description refers to the accompanying drawings, the same numerals in different accompanying drawings indicate the same or similar elements, unless otherwise indicated.

If there are terms related to directional indications or positional relationships (e.g., upper, lower, left, right, front, rear, inner, outer, top, bottom, center, vertical, horizontal, longitudinal, transverse, length, width, counterclockwise, clockwise, axial, radial, circumferential, etc.) in embodiments of the present disclosure, such terms are only used to explain relative positional relationships, movement states, etc., between various components in a specific posture; if the specific posture changes, the directional indications or positional relationships may change accordingly. In addition, terms such as "first", "second", etc. involved in embodiments of the present disclosure are only used for descriptive purposes, and are not be construed as indicating or implying a relative importance.

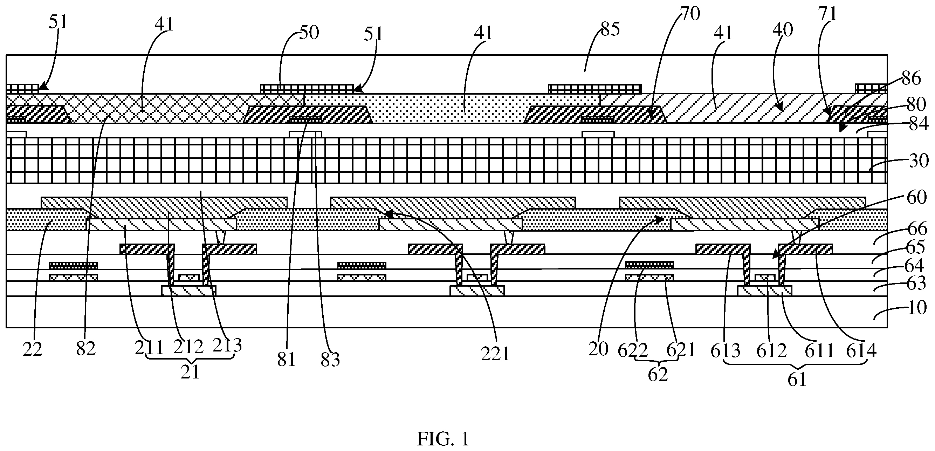

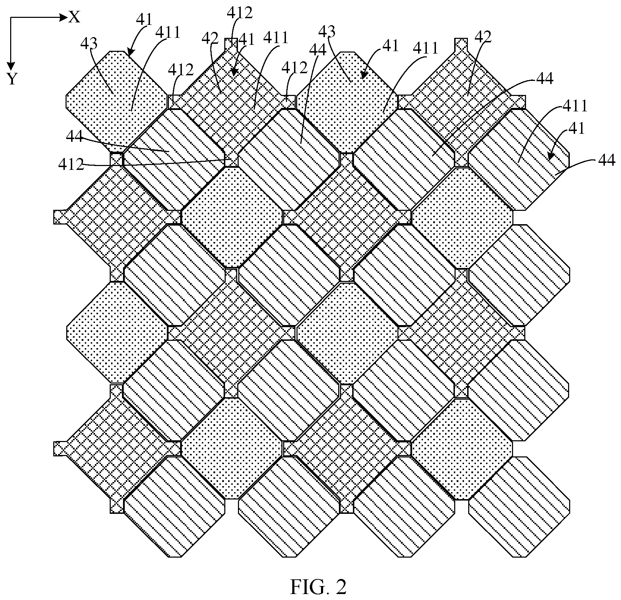

Embodiments of the present disclosure provide a display substrate. As shown in FIG. 1, the display substrate includes a substrate 10, a light-emitting layer 20, a color filter layer 40 and a light-shielding layer 50. The light-emitting layer 20 is located on the substrate 10, and the light-emitting layer 20 includes a plurality of sub-pixels 21 arranged at intervals. The color filter layer 40 is located on a side of the light-emitting layer 20 away from the substrate 10, and the color filter layer 40 includes a plurality of color filter portions 41. The light-shielding layer 50 is at least partially located on a side of the color filter layer 40 away from the substrate 10; the light-shielding layer 50 is provided with a plurality of openings 51, and an orthographic projection of each opening 51 on the substrate 10 falls within an orthographic projection of a respective color filter portion 41 on the substrate 10. As shown in FIGS. 2 to 8, each color filter portion 41 includes a main body portion 411, at least one color filter portion 41 includes a protruding portion 412 connected to the main body portion 411, and each protruding portion 412 is located between main body portions 411 of two adjacent color filter portions 41.

In the display substrate provided in embodiments of the present disclosure, by configuring the at least one color filter portion 41 in the color filter layer 40 to include a protruding portion 412 connected to a main body portion 411, and the protruding portion 412 to be arranged between main body portions 411 of two adjacent color filter portions 41, the protruding portion 412 may reduce a gap between adjacent color filter portions 41, which may mitigate breakage of the light-shielding layer 50 formed on the color filter portion 41 caused by an excessively large distance between the adjacent color filter portions 41. In addition, it is also possible to mitigate color separation resulting from diffraction of light emitted by the sub-pixels 21 when passing through the broken part of the light-shielding layer 50, and the problem of a display defect of black spots appearing during the display of the display substrate caused by particles, generated during the breakage of the light-shielding layer 50, falling at a position where the color filter portion 41 opposes to the opening 51 of the light-shielding layer 50. By arranging the light-shielding layer 50 on the side of the color filter layer 40 away from the substrate, it is possible to improve a dark state effect of the display substrate in a non-display state. By providing the color filter layer 40, the color filter layer 40 may filter incident external ambient light to reduce an amount of reflection of the incident ambient light, and compared with a polarizer, the color filter layer 40 may reduce a loss of emitted light, thereby improving the light extraction efficiency.

It will be noted that a cross-sectional view in FIG. 1 is a partial schematic view of a display substrate taken along a direction perpendicular to a stacking direction of layers.

In an embodiment, the substrate 10 may be a flexible substrate or a rigid substrate. A material of the flexible substrate may include one or more of polyimide, polyethylene terephthalate, polycarbonate, or an organic resin material. The organic resin material may include epoxy resin, triazine, silicone resin or polyimide. The rigid substrate includes any one of a glass substrate, a quartz substrate, a sapphire substrate, etc.

In an embodiment, as shown in FIG. 1, the display substrate further includes a driving circuit layer 60 located between the substrate 10 and the light-emitting layer 20. The driving circuit layer 60 includes a plurality of pixel circuits, and the pixel circuits are used to drive sub-pixels 21. The pixel circuits may be in one-to-one correspondence with the sub-pixels 21, and each pixel circuit is used to drive a corresponding sub-pixel 21.

In an embodiment, as shown in FIG. 1, the sub-pixel 21 includes a first electrode 211, a light-emitting material layer 212 located on a side of the first electrode 211 away from the substrate 10, and a second electrode 213 located on a side of the light-emitting material layer 212 away from the substrate 10. One of the first electrode 211 and the second electrode 213 is an anode, and the other is a cathode. In FIG. 1, the first electrode 211 is an anode, the second electrode 213 is a cathode, the cathode is a common electrode, and cathodes of all sub-pixels 21 are connected to form a sheet electrode. In some embodiments, the light-emitting material layer 212 is an organic light-emitting material layer, and the sub-pixel 21 is an OLED.

In an embodiment, as shown in FIG. 1, the pixel circuit may include a thin film transistor 61 and a capacitor 62. The thin film transistor 61 may include an active layer 611, a gate electrode 612, a first terminal 613 and a second terminal 614. One of the first terminal 613 and the second terminal 614 is a source electrode, and the other is a drain electrode. The capacitor 62 includes a first plate 621 and a second plate 622 arranged opposite to each other. The pixel circuit layer may further include a plurality of signal lines, such as scanning signal lines, data signal lines, power supply signal lines, etc.

In an embodiment, as shown in FIG. 1, the gate electrode 612 and the first plate 621 of the capacitor 62 are located in a same layer, the second plate 622 of the capacitor 62 is located on a side of the first plate 621 away from the substrate 10, and the first terminal 613 and the second terminal 614 of the thin film transistor 61 are located in a same layer and on a side of the second plate 622 away from the substrate 10. The driving circuit layer 60 further includes: a gate insulating layer 63 located between the active layer 611 and the gate electrode 612, a capacitor insulating layer 64 located between the gate electrode 612 and the second plate 622, an interlayer dielectric layer 65 located between the second plate 622 and the first terminal 613, and a planarization layer 66 located between the first terminal 613 and the first electrode 211. The first electrode 211 is electrically connected to the second terminal 614 through a via hole penetrating through the planarization layer 66, and the first terminal 613 and the second terminal 614 are in contact with the active layer 611 through via holes respectively penetrating through the interlayer dielectric layer 65, the capacitor insulating layer 64 and the gate insulating layer 63.

In an embodiment, the light-emitting layer 20 includes sub-pixels 21 of at least three different emission colors, the sub-pixels 21 may be in one-to-one correspondence with the color filter portions 41, and an orthographic projection of each sub-pixel 21 on the substrate 10 falls within an orthographic projection of a corresponding color filter portion 41 on the substrate 10; an emission color of each sub-pixel 21 is the same as a color of a corresponding color filter portion 41 in the color filter layer 40. For example, the light-emitting layer 20 includes a sub-pixel having an emission color of a first color, a sub-pixel having an emission color of a second color, and a sub-pixel having an emission color of a third color. As shown in FIGS. 2 to 8, the color filter layer 40 includes a first color filter portion 42, a second color filter portion 43 and a third color filter portion 44. In some embodiments, the light-emitting layer 20 may include a sub-pixel emitting red light, a sub-pixel emitting green light, and a sub-pixel emitting blue light, and therefore the color filter layer 40 includes a red filter portion, a blue filter portion and a green filter portion.

In an embodiment, as shown in FIG. 1, the light-emitting layer 20 further includes a pixel defining layer 22 provided with a plurality of pixel openings 221. The pixel defining layer 22 is located on a side of the first electrode 211 away from the substrate 10. The pixel openings 221 may be in one-to-one correspondence with the sub-pixels 21, and each pixel opening 221 exposes at least a portion of a corresponding first electrode 211. At least a portion of the light-emitting material layer 212 of each sub-pixel 21 is located in the pixel opening 221. At least a portion the second electrode 213 is located on a side of the pixel defining layer 22 away from the substrate 10. Each pixel opening 221 defines a light-emitting region of the corresponding sub-pixel 21. Specifically, a region defined by a bottom surface of the pixel opening 221 facing the substrate 10 is the light-emitting region of the sub-pixel 21.

In an embodiment, as shown in FIG. 1, in a direction from the substrate 10 toward the second electrode 213, a side surface of the pixel opening 221 is inclined and extends outward. The pixel defining layer 22 may be formed by exposure and development processes, so as to form a pixel opening 221 having such a shape.

In an embodiment, as shown in FIG. 1, the display substrate further includes an encapsulation layer 30 located between the light-emitting layer 20 and the light-shielding layer 50, and both the color filter layer 40 and the light-shielding layer 50 are located on a side of the encapsulation layer 30 away from the substrate 10. The encapsulation layer 30 may be a thin film encapsulation layer including organic layers and inorganic layers arranged alternately, and a layer farthest away from the substrate 10 is an inorganic layer. In some embodiments, the thin film encapsulation layer may include two inorganic layers and an organic layer located between the two inorganic layers.

In an embodiment, as shown in FIG. 1, the display substrate further includes a touch structure layer 80 located between the encapsulation layer 30 and the color filter layer 40; the touch structure layer 80 includes a first touch electrode layer 83, a second touch electrode layer 81 located on a side of the first touch electrode layer 83 away from the substrate 10, an insulating material layer 84 located between the first touch electrode layer 83 and the second touch electrode layer 81, and an insulating protection layer 86 located on a side of the second touch electrode layer 81 away from the substrate 10, where the insulating protection layer 86 covers the second touch electrode layer 81. The second touch electrode layer 81 may include a plurality of first touch electrodes, a plurality of second touch electrodes and a plurality of first connecting portions, and the first touch electrode layer 83 includes a plurality of second connecting portions. Adjacent first touch electrodes may be connected with each other through the first connecting portion, and adjacent second touch electrodes may be electrically connected with each other through the second connecting portion. Materials of the insulating protection layer 86 and the insulating material layer 84 may be organic materials, and surfaces of the insulating protection layer 86 and the insulating material layer 84 away from the substrate 10 have good flatness. In some embodiments, the materials of the insulating protection layer 86 and the insulating material layer 84 may each be an organic resin.

In an embodiment, as shown in FIG. 1, the display substrate further includes an insulating layer 70 provided with a plurality of through holes 71, and each color filter portion 41 is partially located in a through hole 71. The color filter portions 41 may be in one-to-one correspondence with the through holes 71, and a portion of each color filter portion 41 is located in a corresponding through hole 71. In a direction from the substrate 10 toward the insulating layer 70, a side surface of the through hole 71 is inclined and extends outward. The through hole 71 of the insulating layer 70 may be formed by exposure and development processes, so as to form the through hole 71 having such a shape.

Further, a refractive index of the insulating layer 70 is less than a refractive index of the color filter portion 41. With this arrangement, after light emitted by the sub-pixels 21 is incident from the color filter portions 41 to the side surface of the through hole 71 of the insulating layer 70, most of the light undergoes a total reflection at the side surface of the through hole 71 of the insulating layer 70 and is emitted through the light-shielding layer 50, which facilitates reducing light loss and improving the light extraction efficiency of the display substrate. In some embodiments, the refractive index of the insulating layer 70 ranges from 1.4 to 1.55, and the refractive index of the color filter portion 41 ranges from 1.6 to 1.7. As such, a difference between the refractive index of the color filter portions 41 and the refractive index of the insulating layer 70 is large, which may improve a total reflection efficiency of the light incident on the side surface of the through hole 71 of the insulating layer 70.

In an embodiment, as shown in FIG. 1, the insulating layer 70 further serves as the insulating protection layer 86, which facilitatese, and the insulating layer 70 is located on a side of the insulating protection layer 86 away from the substrate 10.

In an embodiment, as shown in FIG. 1, the display substrate further includes a protective layer 85 located on a side of the light-shielding layer 50 away from the substrate 10, and the protective layer 85 covers a side surface of the opening 51 of the light-shielding layer 50 and a surface of the light-shielding layer 50 away from the substrate 10. A material of the protective layer 85 may be an organic resin.

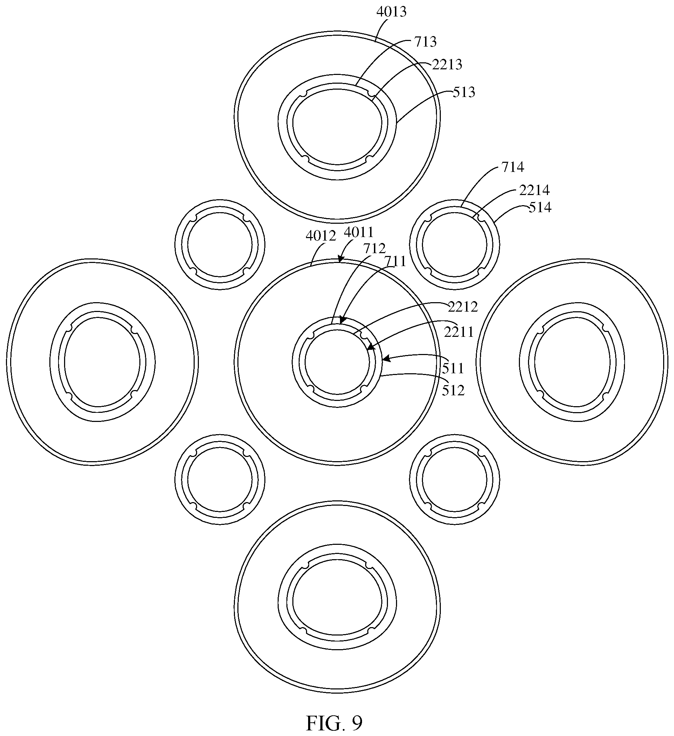

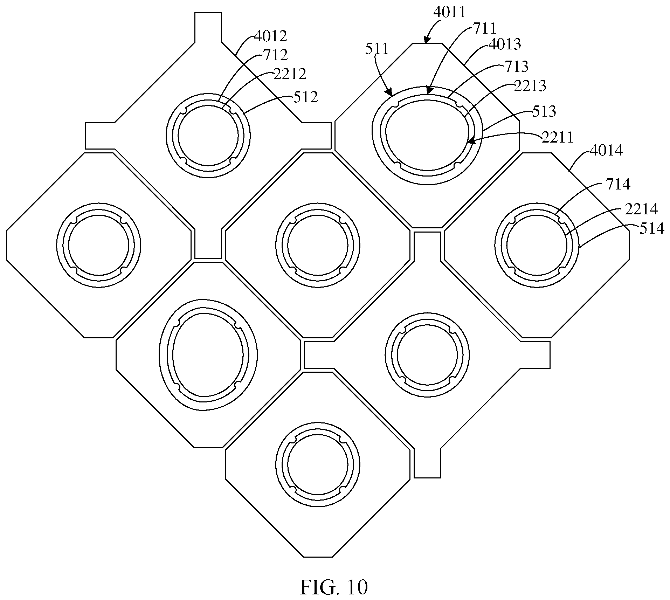

In an embodiment, as shown in FIGS. 9 and 10, an edge of an orthographic projection of a bottom surface of each through hole 71 of the insulating layer 70 facing the substrate 10 on the substrate 10 is a first edge 711, an edge of an orthographic projection of each color filter portion 41 on the substrate 10 is a second edge 4011, and the first edge 711 is located inside a corresponding second edge 4011; an edge of an orthographic projection of a bottom surface of each pixel opening 221 facing the substrate 10 on the substrate 10 is a third edge 2211, and the third edge 2211 is located inside a corresponding first edge 711. By arranging the third edge 2211 inside the corresponding first edge 711, more of the light emitted by the sub-pixels 21 may be incident on a portion of the color filter portion 41 located within the through hole 71 and may be then emitted after being reflected by the insulating layer 70, which is beneficial to improving the light extraction rate. By arranging the first edge 711 inside the corresponding second edge 4011, that is, the color filter portion 41 partially covers the insulating layer 70, a gap between adjacent color filter portions 41 may be reduced, which facilitates avoiding an occurrence of breakage of the light-shielding layer 50.

In an embodiment, as shown in FIGS. 9 and 10, an edge of an orthographic projection of a bottom surface of each opening 51 facing the substrate 10 on the substrate 10 is a fourth edge 511, and the fourth edge 511 is located outside a corresponding first edge 711. With this arrangement, an amount of light emitted through the through hole 71 of the insulating layer 70 that is absorbed by the light-shielding layer 50 may be reduced, thereby reducing light loss and improving the light extraction rate of the display substrate.

As shown in FIGS. 9 and 10, an edge of an orthographic projection of the first color filter portion on the substrate 10 is a second edge 4012, an edge of an orthographic projection of the second color filter portion on the substrate 10 is a second edge 4013, and an edge of an orthographic projection of the third color filter portion on the substrate 10 is a second edge 4014; a first edge of the through hole 71 corresponding to the first color filter portion is a first edge 712, a first edge of the through hole 71 corresponding to the second color filter portion is a first edge 713, and a first edge of the through hole 71 corresponding to the third color filter portion is a first edge 714; a third edge of the pixel opening 221 corresponding to the first color filter portion is a third edge 2212, a third edge of the pixel opening 221 corresponding to the second color filter portion is a third edge 2213, and a third edge of the pixel opening 221 corresponding to the third color filter portion is a third edge 2214; an edge of an orthographic projection of a bottom surface of the opening 51 corresponding to the first color filter portion facing the substrate 10 on the substrate 10 is a fourth edge 512, an edge of an orthographic projection of a bottom surface of the opening 51 corresponding to the second color filter portion facing the substrate 10 on the substrate 10 is a fourth edge 513, and an edge of an orthographic projection of a bottom surface of the opening 51 corresponding to the third color filter portion facing the substrate 10 on the substrate 10 is a fourth edge 514. The second edge 4012 of the first color filter portion is located outside a corresponding fourth edge 512, the fourth edge 512 is located outside a corresponding first edge 712, and the first edge 712 is located outside a corresponding third edge 2212; the second edge 4013 of the second color filter portion is located outside a corresponding fourth edge 513, the fourth edge 513 is located outside a corresponding first edge 713, and the first edge 713 is located outside a corresponding third edge 2213; the second edge 4014 of the third color filter portion is located outside a corresponding fourth edge 514, the fourth edge 514 is located outside a corresponding first edge 714, and the first edge 714 is located outside a corresponding third edge 2214.

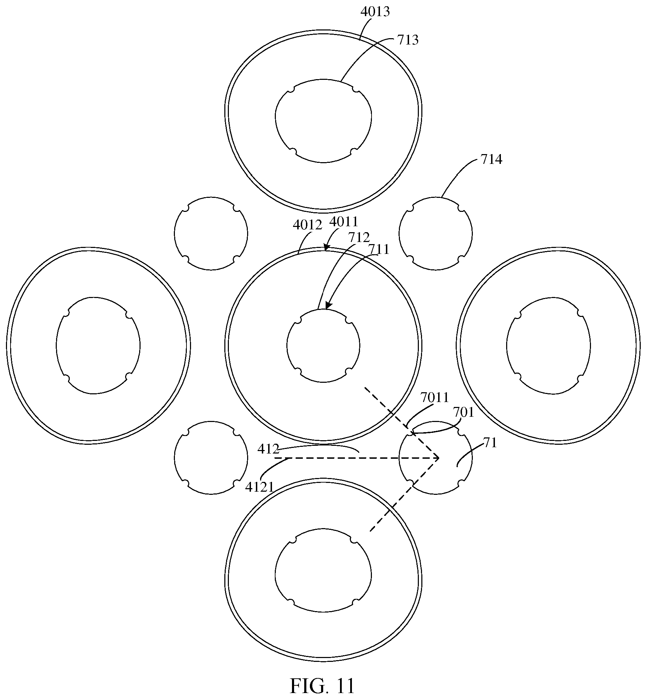

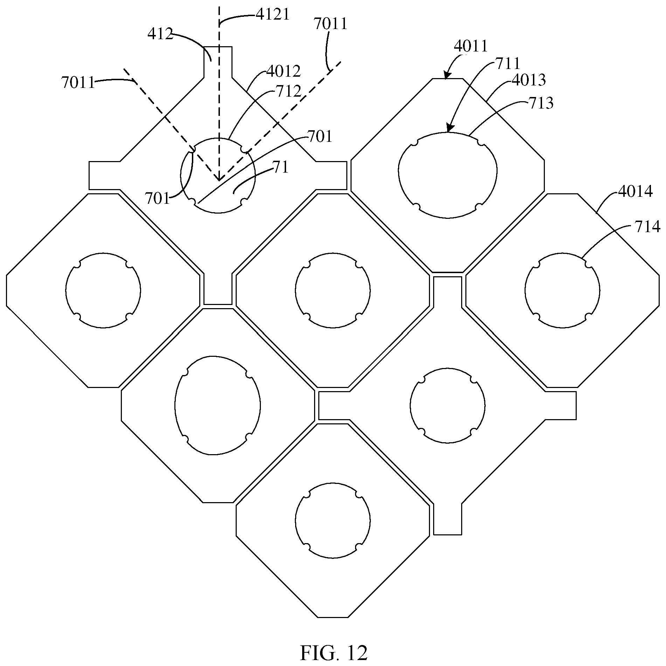

In an embodiment, as shown in FIGS. 11 and 12, a side surface of at least one through hole 71 of the insulating layer 70 is provided with a protrusion 701, and the protrusion 701 extends toward a center of the through hole 71 where the protrusion 701 is located. By providing the protrusion 701 on the side surface of the through hole 71, an area of the side surface of the through hole 71 may be increased, thereby allowing more of light incident on the side surface of the through hole 71 to be reflected, which is beneficial to increasing forward light output of the display substrate.

In an embodiment, a side surface of the protrusion 701 is curved.

In some embodiments, the side surface of the protrusion 701 may be a conical surface, and a cross-sectional area of the protrusion 701 parallel to the substrate 10 gradually decreases in a direction from the substrate 10 toward the color filter layer. Since an outer side surface of the protrusion 701 is a conical surface or a curved side surface of a truncated cone, compared with a case where the side surface of the through hole 71 is not provided with a protrusion thereon, most of light incident on the side surface of the protrusion 701 from the color filter portion 41 from various directions may be emitted at similar exit angles after being reflected by the side surface of the protrusion 701, which facilitates increasing the forward light output of the display substrate.

In some embodiments, the side surface of the protrusion 701 is a cylindrical surface, or a cross section of the protrusion 701 parallel to the substrate 10 is semi-elliptical. With this arrangement, compared with the case where the side surface of the through hole 71 is not provided with a protrusion thereon, the light incident on the side surface of the protrusion 701 from the color filter portion 41 from various directions are reflected by the side surface of the protrusion 701, which facilitates adjusting the light incident from various directions to a direction perpendicular to the light-emitting surface of the display panel, thereby increasing the forward light output of the display substrate.

In an embodiment, as shown in FIGS. 11 and 12, the side surface of each through hole 71 is provided with a plurality of protrusions 701, and the plurality of protrusions 701 on the side surface of the same through hole 71 are arranged at equal intervals in a circumferential direction. By providing the plurality of protrusions 701 on the side surface of the through hole 71, more light may be reflected at the side surface of the protrusion 701, which may improve light efficiency of the display panel. In some embodiments, as shown in FIGS. 11 and 12, the side surface of the same through hole 71 is provided with four protrusions 701, and the four protrusions 701 are arranged at equal intervals in the circumferential direction.

In an embodiment, as shown in FIGS. 11 and 12, an axis of the protruding portion 412 of the color filter portion 41 passing through a center of the color filter portion 41 is a first axis 4121, an axis of the protrusion 701 of the through hole 71 passing through a center of the through hole 71 is a second axis 7011, and an included angle between the first axis 4121 of the protruding portion 412 and one of second axes 7011 of two protrusions 701 adjacent to the protruding portion 412 in a corresponding through hole 71 is equal to an included angle between the first axis 4121 of the protruding portion 412 and the other of the second axes 7011 of the two protrusions 701 adjacent to the protruding portion 412 in the corresponding through hole 71. With this arrangement, color shift of light at a side viewing angle may be reduced, thereby improving user experience. The center of the color filter portion 41 coincides with the center of the corresponding through hole.

Further, as shown in FIGS. 11 and 12, the through hole 71 is provided with four protrusions 701 that are arranged at equal intervals in the circumferential direction, and the included angle between the first axis 4121 of the protruding portion 412 and the second axe 7011 of each of the two protrusions 701 adjacent to the protruding portion 412 in the corresponding through hole 71 is 45°. In an embodiment, as shown in FIGS. 2 to 8, all the color filter portions 41 of the color filter layer 40 are arranged into a plurality of first filter portion groups and a plurality of second filter portion groups. The plurality of first filter portion groups are arranged in a first direction Y, and the plurality of second filter portion groups are arranged in a second direction X. Each first filter portion group includes a plurality of color filter portions 41 arranged in the second direction X, each second filter portion group includes a plurality of color filter portions 41 arranged in the first direction Y, and the first direction Y intersects the second direction X. In some embodiments, the first direction Y is perpendicular to the second direction X. In some embodiments, the first direction Y is a column direction and the second direction X is a row direction, that is, all the color filter portions 41 of the color filter layer 40 are arranged in a plurality of rows and columns. The following description will be introduced by taking the first direction Y as the column direction and the second direction X as the row direction as an example.

In an embodiment, the color filter layer 40 includes a first color filter portion 42, a second color filter portion 43 and a third color filter portion 44; for two adjacent rows of color filter portions, first color filter portions 42 and second color filter portions 43 in one row of color filter portions are arranged alternately, and each color filter portion in the other row of color filter portions is a third color filter portion 44. For two adjacent columns of color filter portions, first color filter portions 42 and second color filter portions 43 in one column of color filter portions are arranged alternately, and each color filter portion in the other column of color filter portions is a third color filter portion 44. The plurality of color filter portions in a same row are arranged in the second direction X, and the plurality of color filter portions in a same column are arranged in the first direction Y.

In an embodiment, as shown in FIGS. 2 to 8, opposing portions of outlines of at least two adjacent color filter portions 41 have a same shape. With this arrangement, the gap between the two adjacent color filter portions 41 may be reduced, thereby further mitigating the risk of breakage of the light-shielding layer 50.

Further, as shown in FIGS. 2 to 8, opposing portions of outlines of any two adjacent color filter portions 41 in the row direction X have a same shape, and opposing portions of outlines of any two adjacent color filter portions 41 in the column direction Y have a same shape. With this arrangement, a gap between any two adjacent color filter portions 41 may be minimized, which may effectively mitigate the problem of breakage of the light-shielding layer 50.

In an embodiment, as shown in FIGS. 2 to 5, each of the opposing portions of the outlines of the at least two adjacent color filter portions 41 is linear, and the opposing linear portions of the outlines of the two adjacent color filter portions 41 are parallel to each other. With this arrangement, a gap between the opposing portions of the two adjacent color filter portions 41 has the same size, which may effectively mitigate the problem of a large gap at some positions between two adjacent color filter portions 41. The term "parallel" used herein refers to being substantially parallel, including a case of being strictly parallel and a case where an included angle between two is very small, for example, the included angle between the two being less than 10° may be considered as being parallel.

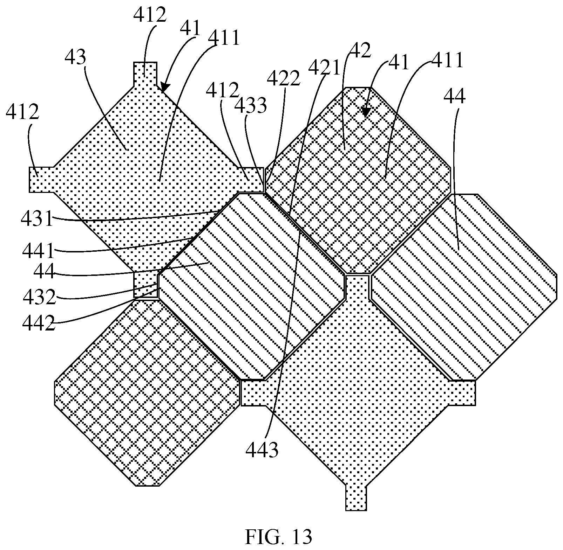

As shown in FIG. 13, a segment 431 of an outline of the color filter portion 43 opposes a segment 441 of an outline of the color filter portion 44 adjacent to the color filter portion 43, and both the segment 431 and the segment 441 are straight lines and parallel to each other; a segment 432 of the outline of the color filter portion 43 opposes a segment 442 of the outline of the color filter portion 44 adjacent to the color filter portion 43, and both the segment 432 and the segment 442 are straight lines and parallel to each other; a segment 421 of the outline of the color filter portion 42 opposes a segment 443 of the outline of the color filter portion 44 adjacent to the color filter portion 42, and both the segment 421 and the segment 443 are straight lines and parallel to each other; a segment 422 of the outline of the color filter portion 42 is opposite to a segment 433 of the outline of the color filter portion 43 adjacent to the color filter portion 42, and both the segment 422 and the segment 433 are straight lines and parallel to each other.

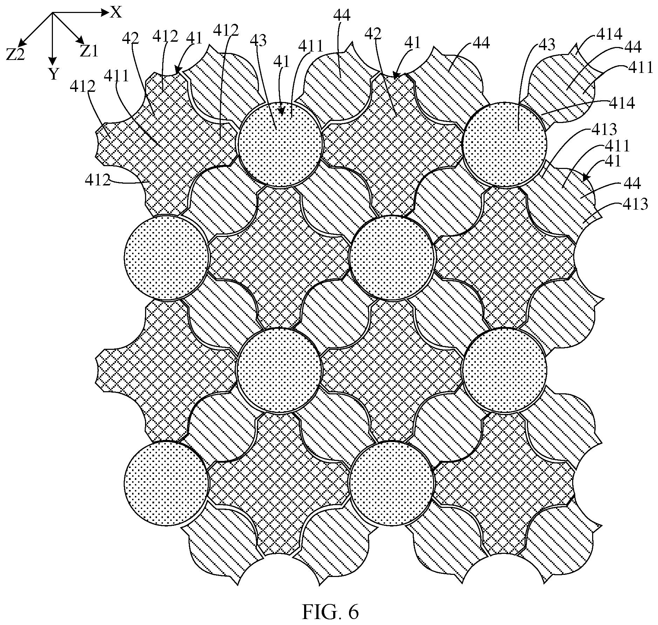

In an embodiment, as shown in FIGS. 6 to 8, the opposing portions of the outlines of the at least two adjacent color filter portions 41 are curved, and the opposing portions of the outlines of the at least two adjacent color filter portions 41 have the same shape. By configuring a portion of the outline of the color filter portion 41 to be curved, the shape of the color filter portion 41 may be flexibly designed, thereby allowing for flexible adjustment of areas of the color filter portions 41 of various colors, so as to optimize a dark state effect of the display substrate in a non-display state and a white balance effect of the display substrate.

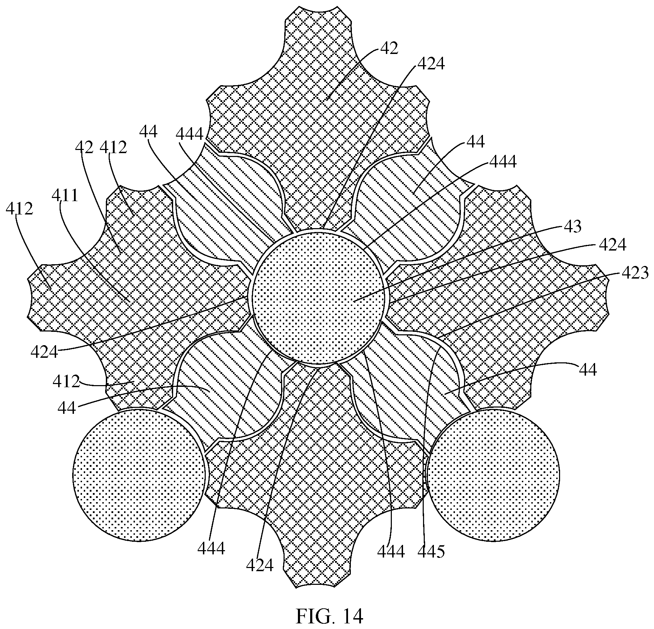

As shown in FIG. 14, the outline of the color filter portion 43 is circular, a segment 424 of the outline of each color filter portion 42 opposes a segment of the outline of the adjacent color filter portion 43 adjacent to the color filter portion 42, and each segment 424 is an arc; a segment 423 of the outline of each color filter portion 42 opposes a segment 445 of the outline of the color filter portion 44 adjacent to the color filter portion 42, and each of the segment 423 and the segment 445 is a curve including two straight segments and an arc segment.

In an embodiment, at least one color filter portion 41 is surrounded by a plurality of color filter portions 41, an outline of the surrounded color filter portion 41 is a smooth closed curve, and portions of outlines of the plurality of surrounding color filter portions 41 that oppose the surrounded color filter portion 41 are located on a same smooth closed curve. With this arrangement, a gap between the surrounded color filter portion and each of the surrounding color filter portions may be reduced, so that it is possible to effectively reduce the probability of breakage of the light-shielding layer 50.

Further, a geometric center of the smooth closed curve where the portions of the outlines of the plurality of color filter portions that oppose the surrounded color filter portion are located is a first center, a geometric center of the outline of the surrounded color filter portion 41 is a second center, and the first center coincides with the second center. With this arrangement, gaps between the surrounded color filter portion 41 and the respective surrounding color filter portions 41 may be uniform, which may avoid the problem of breakage of the light-shielding layer 50 at a position where a distance between the surrounded color filter portion 41 and an adjacent color filter portion 41 is large.

As shown in FIG. 14, the outline of the color filter portion 43 is circular, four color filter portions 42 and four color filter portions 44 surround a same color filter portion 43, segments 424 of the outlines of the four color filter portions 42 all oppose the outline of the color filter portion 43, segments 444 of the outlines of the four color filter portions 44 all oppose the outline of the color filter portion 43, and the four sections 424 and the four sections 444 are all arcs and located on the same circle, where a center of the circle coincides with a center of the outline of the color filter portion 43.

In an embodiment, partial outlines of at least two adjacent color filter portions 41 conform to each other. In this way, no gap is formed between partial regions of the two adjacent color filter portions, which may effectively avoid the problem of breakage of the light-shielding layer 50 at that position. In some embodiments, no gap is formed between a plurality of color filter portions 41 and their adjacent color filter portions 41.

In an embodiment, a maximum width of the gap between any two adjacent color filter portions 41 is less than or equal to 3 µm. When the maximum width of the gap between two adjacent color filter portions 41 is less than or equal to 3 µm, breakage of the light-shielding layer 50 at the gap may be avoided. The above-mentioned configuration may effectively avoid problems of color separation and black spot defects during the display of the display substrate caused by the breakage of the light-shielding layer. In some embodiments, the maximum width of the gap between any two adjacent color filter portions 41 is less than or equal to 1 µm.

In an embodiment, as shown in FIGS. 2 to 8, each of a plurality of color filter portions 41 in the color filter layer 40 includes a main body portion 411 and at least one protruding portion 412 connected to the main body portion 411; a region between main body portions 411 of two adjacent color filter portions 41 in a same row is filled with the protruding portion 412; a region between main body portions 411 of two adjacent color filter portions 41 in a same column is filled with the protruding portion 412. With this arrangement, the gap between the main body portions 411 of two adjacent color filter portions 41 in the same row is small, and the gap between the main body portions 411 of two adjacent color filter portions 41 in the same column is small, thereby effectively improving the problem of a large gap between two adjacent color filter portions 41 in the color filter layer 40, so that it is possible to further effectively mitigate the problem of breakage of the light-shielding layer 50.

In an embodiment, the color filter layer includes color filter portions of at least three different colors; and protruding portions filled between any two adjacent main body portions are all protruding portions of a same color.

As shown in FIG. 2, each first color filter portions 42 has protruding portions 412 on opposite sides in both the row direction X and the column direction Y. In the color filter layer 40, the protruding portion 412 filled between the main body portions 411 of two adjacent color filter portions 41 in the same row and the protruding portion 412 filled between any two adjacent main body portions 411 in the same column are both protruding portions of the first color filter portions 42. All other color filter portions except the first color filter portion 42 may each include a main body portion. Specifically, the protruding portion 412 of the first color filter portion 42 is filled between the main body portion 411 of the first color filter portion 42 and the main body portion 411 of the second color filter portion 43 adjacent to each other and located in the same row, and the protruding portion 412 of the first color filter portion 42 is filled between the main body portions 411 of two adjacent third color filter portions 44 in the same row; the protruding portion 412 of the first color filter portion 42 is filled between the main body portion 411 of the first color filter portion 42 and the main body portion 411 of the second color filter portion 43 that are adjacent to each other and located in the same column; and the protruding portion 412 of the first color filter portion 42 is filled between the main body portions 411 of two adjacent third color filter portions 44 in the same column.

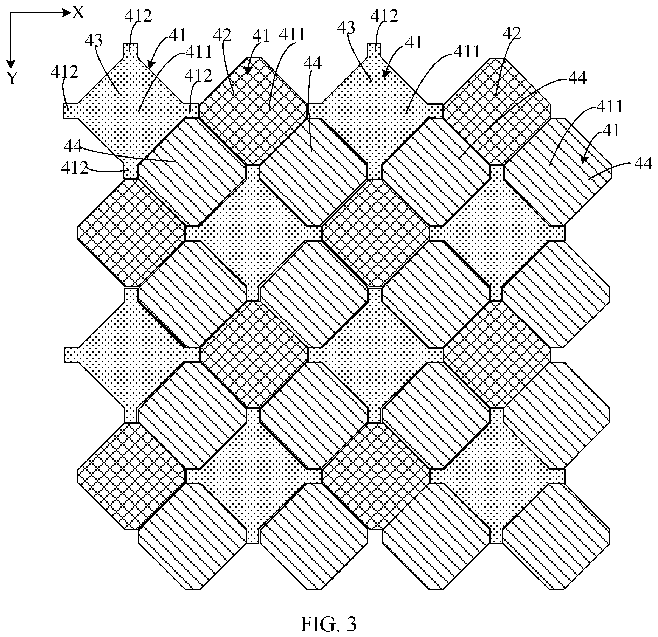

As shown in FIG. 3, each second color filter portions 43 has protruding portions 412 on opposite sides in both the row direction X and the column direction Y. In the color filter layer 40, the protruding portion 412 filled between the main body portions 411 of two adjacent color filter portions 41 in the same row and the protruding portion 412 filled between any two adjacent main body portions 411 in the same column are both protruding portions of the second color filter portions 43. Specifically, the protruding portion 412 of the second color filter portion 43 is filled between the main body portion 411 of the first color filter portion 42 and the main body portion 411 of the second color filter portion 43 that are adjacent to each other and located in the same row, and the protruding portion 412 of the second color filter portion 43 is filled between the main body portions 411 of two adjacent third color filter portions 44 in the same row; the protruding portion 412 of the second color filter portion 43 is filled between the main body portion 411 of the first color filter portion 42 and the main body portion 411 of the second color filter portion 43 that are adjacent to each other and located in the same column, and the protruding portion 412 of the second color filter portion 43 is filled between the main body portions 411 of two adjacent third color filter portions 44 in the same column.

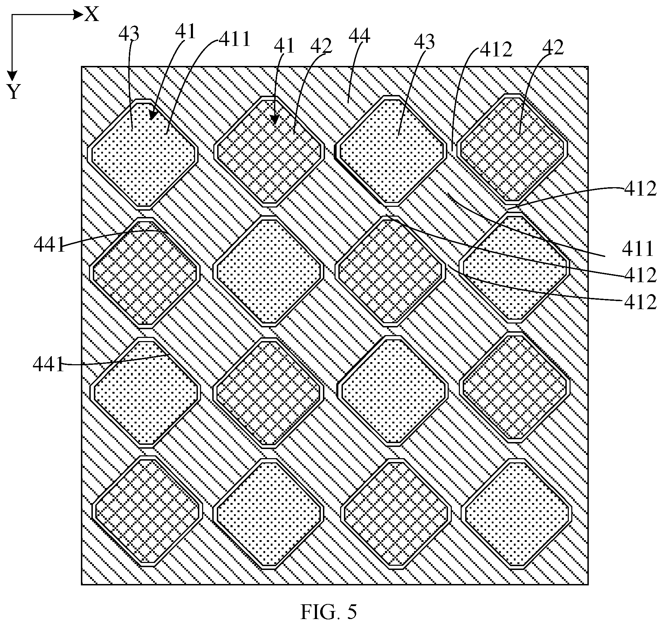

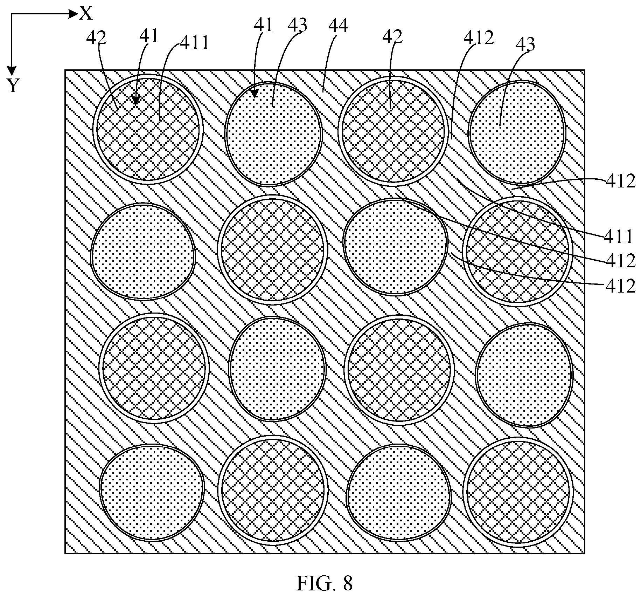

As shown in FIGS. 5 and 8, each third color filter portions 44 has protruding portions 412 on opposite sides in both the row direction X and the column direction Y. In the color filter layer 40, the protruding portion 412 filled between the main body portions 411 of two adjacent color filter portions 41 in the same row and the protruding portion 412 filled between any two adjacent main body portions 411 in the same column are both protruding portions of the third color filter portions 44, and third color filter portions 44 are formed as a continuous structure. Specifically, the protruding portion 412 of the third color filter portion 44 is filled between the main body portion 411 of the first color filter portion 42 and the main body portion 411 of the second color filter portion 43 that are adjacent to each other and located in the same row, and the protruding portion 412 of the third color filter portion 44 is filled between the main body portions 411 of two adjacent third color filter portions 44 in the same row; the protruding portion 412 of the third color filter portion 44 is filled between the main body portion 411 of the first color filter portion 42 and the main body portion 411 of the second color filter portion 43 that are adjacent to each other and located in the same column, and the protruding portion 412 of the third color filter portion 44 is filled between the main body portions 411 of two adjacent third color filter portions 44 in the same column. By configuring all the third color filter portions 44 as a continuous structure, no gap is formed between adjacent third color filter portions 44, which may further mitigate the problem of breakage of the light-shielding layer.

In an embodiment, the color filter layer 40 includes color filter portions of at least three different colors; and protruding portions of two colors are filled between the main body portions 411 of at least two adjacent color filter portions 41. By filling the protruding portions of two colors between the main body portions 411 of two adjacent color filter portions 41, it helps to adjust areas sizes of the two color filter portions 41 of the two colors, thereby further improving the dark state effect of the display substrate in the non-display state.

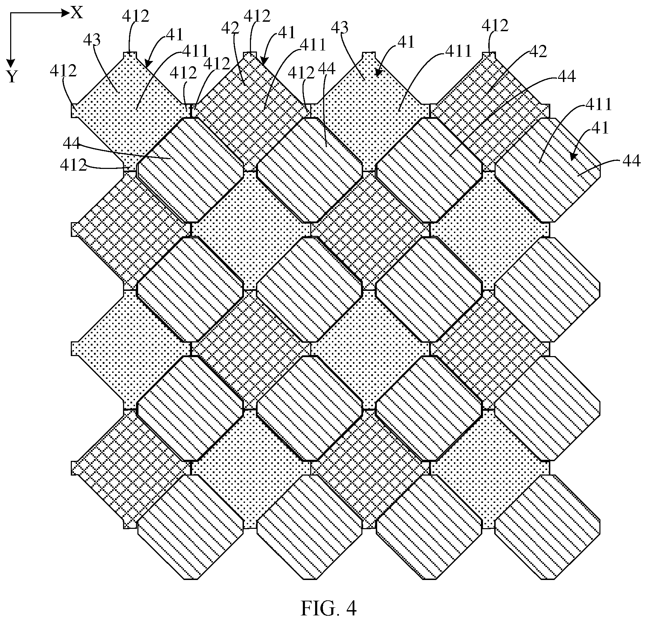

Further, as shown in FIG. 4, each of the first color filter portions 42 and the second color filter portions 43 has protruding portions 412 on opposite sides in both the row direction X and the column direction Y; the protruding portion 412 of the first color filter portion 42 and the protruding portion 412 of the second color filter portion 43 are both filled between the main body portions 411 of two color filter portions 41 in the same row; the protruding portion 412 of the first color filter portion 42 and the protruding portion 412 of the second color filter portion 43 are both filled between the main body portions 411 of two color filter portions 41 in the same column. In the embodiment shown in FIG. 4, the protruding portion 412 of the first color filter portion 42 and the protruding portion 412 of the second color filter portion 43 are filled between the main body portion 411 of the first color filter portion 42 and the main body portion 411 of the second color filter portion 43 that are adjacent to each other and located in the same row, and the protruding portion 412 of the first color filter portion 42 and the protruding portion 412 of the second color filter portion 43 are filled between the main body portions 411 of two adjacent third color filter portions 44 in the same row; the protruding portion 412 of the first color filter portion 42 and the protruding portion 412 of the second color filter portion 43 are filled between the main body portion 411 of the first color filter portion 42 and the main body portion 411 of the second color filter portion 43 that are adjacent to each other and located in the same column, and the protruding portion 412 of the first color filter portion 42 and the protruding portion 412 of the second color filter portion 43 are filled between the main body portions 411 of two adjacent third color filter portions 44 in the same column. This arrangement is more conducive to adjusting a total area of the first color filter portion 42 and the second color filter portion 43, which facilitates improving the dark state effect of the display substrate in the non-display state.

Further, the first color is red, the second color is blue, an area of a main body portion of the first color filter portion 42 is equal to an area of a main body portion of the second color filter portion 43, and an area of a protruding portion of the first color filter portion 42 is equal to an area of a protruding portion of the second color filter portion 43. With this arrangement, a difference between the total area of the first color filter portion 42 and the total area of the second color filter portion 43 in the color filter layer 40 may be effectively reduced, resulting in an optimal dark state effect of the display substrate in the non-display state. In some embodiments, the main body portion 411 of the first color filter portion 42 and the second color filter portion 43 have a same shape, and the protruding portion 412 of the first color filter portion 42 and the second color filter portion 43 have a same shape.

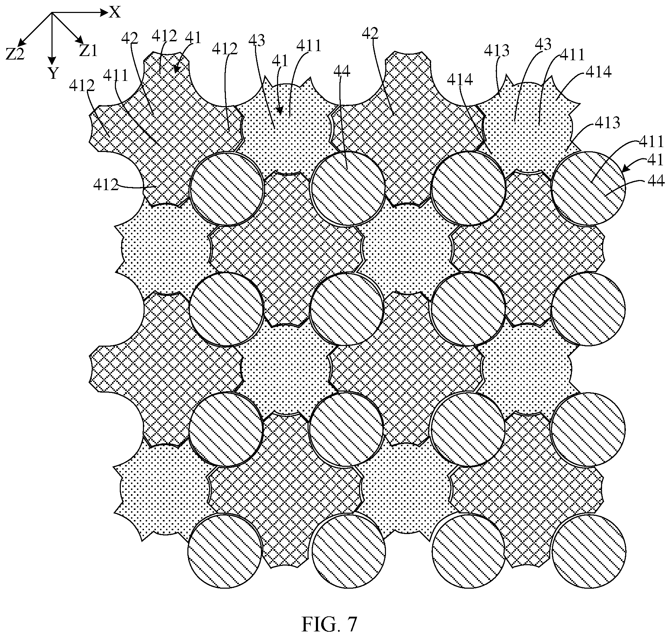

In an embodiment, as shown in FIGS. 6 and 7, at least one color filter portions 41 has protruding portions 413 on opposite sides in a third direction Z1, and the third direction Z1 intersects both the row direction X and the column direction Y. With this arrangement, a gap between the color filter portion 41 and its adjacent color filter portions 41 in the third direction Z1 may be small, thereby further reducing the risk of breakage of the light-shielding layer 50. In the embodiment shown in FIG. 6, among all the third color filter portions 44 located in the same row, half of the third color filter portions 44 each have protruding portions 413 on opposite sides in the third direction Z1. In the embodiment shown in FIG. 7, each second color filter portions 43 has protruding portions 413 on opposite sides in the third direction Z1.

In an embodiment, as shown in FIGS. 6 and 7, at least one color filter portion 41 has protruding portions 414 on opposite sides in a fourth direction Z2, and the fourth direction Z2 intersects both the row direction X and the column direction Y and is perpendicular to the third direction Z1. With this arrangement, a gap between the color filter portion 41 and its adjacent color filter portions 41 in the fourth direction Z2 may be small, thereby further reducing the risk of breakage of the light-shielding layer 50. In the embodiment shown in FIG. 6, among all the third color filter portions 44 located in the same row, half of the third color filter portions 44 each have protruding portions 414 on opposite sides in the fourth direction Z2. In the embodiment shown in FIG. 7, each second color filter portions 43 has protruding portions 414 on opposite sides in the fourth direction Z2.

Preferably, as shown in FIG. 7, each second color filter portions 43 has protruding portions 413 on opposite sides in the third direction Z1 and protruding portions 414 on opposite sides in the fourth direction Z2.

In an embodiment, distances between a surface of each color filter portion 41 in the color filter layer 40 away from the substrate 10 and the substrate 10 are the same. With this arrangement, the surface of each color filter portion 41 away from the substrate 10 is in a same plane, so that a height difference between different color filter portions 41 may be avoided, thereby reducing the risk of breakage of the light-shielding layer 50.

The embodiments of the present disclosure further provide a display apparatus. The display apparatus includes the display substrate in any of the above-mentioned embodiments.

In an embodiment, the display apparatus further includes a driver and a power supply circuit, where the driver is used to provide a driving signal for driving a sub-pixel to emit light, and the power supply circuit is used to supply power to the display substrate.

In an embodiment, the display apparatus further includes a housing, and the display substrate is disposed in the housing.

The display apparatus provided in embodiments of the present disclosure may be any device with a display function, such as a mobile phone, a tablet computer, a television, a notebook computer, a vehicle-mounted device, etc.

It will be noted that, in a case of no conflicts, the technical solutions or technical features described in the above-mentioned embodiments may be combined or supplemented with each other. The scope of protection of the present disclosure is not limited to the precise structures described in the above-mentioned embodiments and shown in the accompanying drawings. All modifications, equivalent substitutions, improvements, etc. made within the spirit and principle of the present disclosure shall be included in the scope of protection of the present disclosure.

## Claims

1. A display substrate, comprising:
a substrate;
a light-emitting layer located on the substrate, wherein the light-emitting layer comprises a plurality of sub-pixels arranged at intervals;
a color filter layer located on a side of the light-emitting layer away from the substrate, wherein the color filter layer comprises a plurality of color filter portions, each color filter portion comprises a main body portion, at least one color filter portion comprises a protruding portion connected to the main body portion, and each protruding portion is located between two adjacent main body portions; and
a light-shielding layer at least partially located on a side of the color filter layer away from the substrate, wherein the light-shielding layer is provided with a plurality of openings, and an orthographic projection of each opening on the substrate falls within an orthographic projection of a respective color filter portion on the substrate.

2. The display substrate according to claim 1, wherein opposing portions of outlines of at least two adjacent color filter portions have a same shape.

3. The display substrate according to claim 2, wherein each of the opposing portions of the outlines of the at least two adjacent color filter portions is linear, and the opposing linear portions of the outlines of the two adjacent color filter portions are parallel to each other.

4. The display substrate according to claim 2, wherein the opposing portions of the outlines of the at least two adjacent color filter portions are curved.

5. The display substrate according to claim 2, wherein at least one color filter portion is surrounded by a plurality of color filter portions, an outline of the surrounded color filter portion is a smooth closed curve, and portions of outlines of the plurality of surrounding color filter portions that oppose the surrounded color filter portion are located on a same smooth closed curve.

6. The display substrate according to claim 5, wherein a geometric center of the smooth closed curve where the portions of the outlines of the plurality of surrounding color filter portions that oppose the surrounded color filter portion are located is a first center, a geometric center of the outline of the surrounded color filter portion is a second center, and the first center coincides with the second center.

7. The display substrate according to claim 2, wherein partial outlines of at least two adjacent color filter portions conform to each other.

8. The display substrate according to claim 1, wherein a maximum width of a gap between any two adjacent color filter portions is less than or equal to 3 µm.

9. The display substrate according to claim 1, wherein the plurality of color filter portions are arranged into a plurality of first filter portion groups and a plurality of second filter portion groups, the plurality of first filter portion groups are arranged in a first direction, the plurality of second filter portion groups are arranged in a second direction, each first filter portion group comprises a plurality of color filter portions arranged in the second direction, each second filter portion group comprises a plurality of color filter portions arranged in the first direction, and the first direction intersects the second direction; each of the plurality of color filter portions in the color filter layer comprises the main body portion and at least one protruding portion connected to the main body portion; and
a region between main body portions of two adjacent color filter portions in a same first filter portion group is filled with the protruding portion; and a region between main body portions of two adjacent color filter portions in a same second filter portion group is filled with the protruding portion.

10. The display substrate according to claim 9, wherein the color filter layer comprises color filter portions of at least three different colors; and in the color filter layer, the protruding portion filled between any two adjacent main body portions in the same first filter portion group and the protruding portion filled between any two adjacent main body portions in the same second filter portion group are both protruding portions of a same color.

11. The display substrate according to claim 10, wherein the color filter portions of the color filter layer comprise a first color filter portion, a second color filter portion and a third color filter portion; for two adjacent first filter portion groups, a first color filter portion and a second color filter portion in one first filter portion group are arranged alternately, and each color filter portion in the other first filter portion group is a third color filter portion; and for two adjacent second filter portion groups, a first color filter portion and a second color filter portion in one second filter portion group are arranged alternately, and each color filter portion in the other second filter portion group is a third color filter portion; and
each first color filter portion has protruding portions on opposite sides in both the second direction and the first direction, and each of protruding portions filled between any two adjacent main body portions is a protruding portion of a first color filter portion; or each second color filter portion has protruding portions on opposite sides in both the second direction and the first direction, and each of protruding portions filled between any two adjacent main body portions is a protruding portion of a second color filter portion; or each third color filter portion has protruding portions on opposite sides in both the second direction and the first direction, each of protruding portions filled between any two adjacent main body portions is a protruding portion of a third color filter portion, and third color filter portions are formed as a continuous structure.

12. The display substrate according to claim 11, wherein the first color is red, the second color is blue, and the third color is green.

13. The display substrate according to claim 9, wherein the color filter layer comprises color filter portions of at least three different colors; and protruding portions of two colors are filled between at least two adjacent main body portions.

14. The display substrate according to claim 13, wherein the color filter portions of the color filter layer comprise a first color filter portion, a second color filter portion and a third color filter portion; for two adjacent first filter portion groups, a first color filter portion and a second color filter portion in one first filter portion group are arranged alternately, and each color filter portion in the other first filter portion group is a third color filter portion; for two adjacent second filter portion groups, a first color filter portion and a second color filter portion in one second filter portion group are arranged alternately, and each color filter portion in the other second filter portion group is a third color filter portion; each of the first color filter portion and the second color filter portion has protruding portions on opposite sides in both the first direction and the second direction; and a protruding portion of a first color filter portion and a protruding portion of a second color filter portion are filled between two adjacent main body portions in a same first filter portion group, and a protruding portion of a first color filter portion and a protruding portion of a second color filter portion are filled between two adjacent main body portions in the same second filter portion group.

15. The display substrate according to claim 14, wherein the first color is red, the second color is blue, an area of a main body portion of the first color filter portion is equal to an area of a main body portion of the second color filter portion, and an area of a protruding portion of the first color filter portion is equal to an area of a protruding portion of the second color filter portion.

16. The display substrate according to claim 9, wherein the color filter portions of the color filter layer comprise a first color filter portion, a second color filter portion and a third color filter portion; for two adjacent first filter portion groups, a first color filter portion and a second color filter portion in one first filter portion group are arranged alternately, and each color filter portion in the other first filter portion group is a third color filter portion; for two adjacent second filter portion groups, a first color filter portion and a second color filter portion in one second filter portion group are arranged alternately, and each color filter portion in the other second filter portion group is a third color filter portion; the second color filter portion or the third color filter portion has protruding portions on opposite sides in a third direction, and the third direction intersects both the first direction and the second direction; and
the second color filter portion or the third color filter portion has protruding portions on opposite sides in a fourth direction, and the fourth direction intersects both the first direction and the second direction and is perpendicular to the third direction.

17. The display substrate according to claim 16, wherein the first color is red, the second color is blue, and the third color is green.

18. The display substrate according to any one of claims 1 to 17, where distances between a surface of each color filter portion in the color filter layer away from the substrate and the substrate are the same.

19. The display substrate according to any one of claims 1 to 17, further comprising an insulating layer located on a side of the light-emitting layer away from the substrate, wherein the insulating layer is provided with a plurality of through holes, and a main body portion of each color filter portion is partially located in a respective through hole; and an edge of an orthographic projection of a bottom surface of each through hole facing the substrate on the substrate is a first edge, an edge of an orthographic projection of each color filter portion on the substrate is a second edge, and the first edge is located inside a corresponding second edge.

20. The display substrate according to claim 19, further comprising a pixel defining layer located between the substrate and the insulating layer, wherein the pixel defining layer is provided with a plurality of pixel openings, and at least a portion of each sub-pixel is located in a respective pixel opening; an edge of an orthographic projection of a bottom surface of each pixel opening facing the substrate on the substrate is a third edge, and the third edge is located inside a corresponding first edge.

21. The display substrate according to claim 19, wherein a refractive index of the insulating layer is less than a refractive index of the color filter portion.

22. The display substrate according to claim 19, wherein an edge of an orthographic projection of each opening on the substrate is a fourth edge, and the fourth edge is located outside a corresponding first edge.

23. The display substrate according to claim 19, further comprising a touch structure layer located between the light-emitting layer and the color filter layer, wherein the touch structure layer comprises a first touch electrode layer, a second touch electrode layer located on a side of the first touch electrode layer away from the substrate, an insulating material layer located between the first touch electrode layer and the second touch electrode layer, and an insulating protective layer located on a side of the second touch electrode layer away from the substrate.

24. The display substrate according to claim 23, wherein the insulating layer further serves as the insulating protective layer and covers the second touch electrode layer.

25. The display substrate according to claim 19, wherein a side surface of at least one through hole of the insulating layer is provided with at least one protrusion, and the protrusion extends toward a center of the through hole where the protrusion is located.

26. The display substrate according to claim 25, wherein a side surface of the protrusion is conical or cylindrical, or a cross section of the protrusion parallel to the substrate is semi-elliptical.

27. The display substrate according to claim 25, wherein the side surface of the at least one through hole of the insulating layer is provided with a plurality of protrusions arranged at intervals, an axis of the protruding portion passing through a center of the color filter portion where the protruding portion is located is a first axis, an axis of the protrusion passing through the center of the through hole where the protrusion is located is a second axis, and an included angle between the first axis of the protruding portion and one of second axes of two protrusions adjacent to the protruding portion in a corresponding through hole is equal to an included angle between the first axis of the protruding portion and the other of the second axes of the two protrusions adjacent to the protruding portion in the corresponding through hole.

28. The display substrate according to any one of claims 1 to 17, further comprising an encapsulation layer located between the light-emitting layer and the color filter layer.

29. The display substrate according to any one of claims 1 to 17, further comprising a protective layer located on a side of the light-shielding layer away from the substrate.

30. A display apparatus, comprising the display substrate according to any one of claims 1 to 29.
